# EUROPEAN PATENT APPLICATION

(11) **EP 2 148 350 A2**
(43) Date of publication of application: **27.01.2010**
(21) Application number: 09165712.2
(22) Date of filing: 16.07.2009
(51) Int. Cl.: H01H 59/00

(54) **Low work function electrical component**

(30) Priority: 24.07.2008 US 179263
(71) Applicant: General Electric Company, Schenectady, NY 12345 (US)
(72) Inventor: Aimi, Marco Francesco, Niskayuna, NY 12309 (US); Weaver Jr., Stanton Earl, Northville, NY 12134 (US); Reddy, Sudhakar Eddula, 560048, Karnataka (IN); Prakash, Om, 560037, Karnataka (IN); Berkcan, Ertugrul, Clifton Park, NY 12065 (US)
(74) Representative: Illingworth-Law, William Illingworth

(57) **Abstract**

An electrical component is disclosed. The electrical component includes at least two electrical contacts movable relative to each other between an open position and a closed position, wherein at least one of the electrical contacts includes a material having a work function that is less than about 3.5 eV, and wherein the distance between the electrical contacts, in the closed position, is greater than 0 nm and up to about 30 nm. A device including a plurality of electrical switches is also disclosed.

## Description

### BACKGROUND

The invention relates generally to the area of electrical components. More specifically, the invention relates to electrical components that incorporate low work function materials.

Micro-electro-mechanical systems (MEMSs) represent an integration of mechanical elements, such as sensors and actuators, with electronics on a substrate through micro-fabrication technology. While the electronics are fabricated using integrated circuit fabrication techniques, the micro-electro-mechanical components are typically fabricated using compatible micromachining processes, such as lithographic processes. The ability to employ lithographic processes is a key advantage. For instance, it allows great facility to control the characteristic dimensions of MEMSs. Lithographic processes also enable ready scaling of the fabrication processes to fabricate arrays of MEMSs.

MEMS technology is suited to fabricate components, such as actuators or switches, that require a limited range of motion for their operation. Arrays of switches may also be realized based on MEMS technology.

One type of MEMS includes a suspended connecting member, which may be in the form of a movable beam, such as a cantilever. Such a device may further include an actuation mechanism, which may be electrostatic, to cause movement of the suspended connecting member. The movement enables an electrical communication between any two or more parts of the MEMS by causing a "making" and "breaking" of an electrical contact between a surface of the suspended connecting member and a surface of an adjacent part of the MEMS. The movement may also serve as a method to cause a change in the magnitude of electrical communication between the two surfaces in question.

One critical figure of merit of such devices is the electrical contact resistance between the different components that are brought into electrical communication via the movement of the suspended connecting member. A related issue affecting reliability of performance of a MEMS concerns the possibility of arcing between, and/or welding of, the two components under question. This arcing and/or welding may result in uncontrolled variation in the electrical contact resistance, and indeed, may also result in temporary or permanent seizure of the electrical contact.

These issues are of particular relevance when deploying such devices, for instance, in harsh environments. One factor that determines the working of MEMS, such as, a cantilever based MEMS, is the ambient environment in which is positioned the suspended connecting member. Therefore, MEMS are often packaged in hermetic conditions to ensure a "clean" and known environment surrounding its parts. This control of the environment reduces the likelihood of a depression in the performance of the MEMS due contamination build-up on the parts.

Development of reliable and cost-effective MEMSs and MEMS arrays that can function even in harsh environments is one of the challenges facing MEMS technology. Additionally, there is need for MEMS arrays that can be fabricated using techniques that are compatible with existing integrated circuit manufacturing infrastructure.

A MEMS with an improved electrical contact, and one that can be readily manufactured using existing integrated circuit manufacturing infrastructure, would therefore, be highly desirable.

### BRIEF DESCRIPTION

Embodiments of the invention are directed towards an electrical component and an array of electrical components.

An electrical component including at least two electrical contacts movable relative to each other between an open position and a closed position,
wherein at least one of the electrical contacts includes a material having a work function that is less than about 3.5 eV, and wherein the distance between the electrical contacts, in the closed position, is greater than 0 nm and up to about 30 nm.

A device including a plurality of electrical switches, wherein each electrical switch includes at least two electrical contacts movable relative to each other between an open position and a closed position, and wherein at least one of the electrical contacts includes a material having a work function that is less than about 3.5 eV, and wherein the distance between the electrical contacts, in the closed position, is greater than 0 nm and up to about 30 nm.

These and other advantages and features will be more readily understood from the following detailed description of preferred embodiments of the invention that is provided in connection with the accompanying drawings.

### DRAWINGS

Referring to the drawings in general, it will be understood that the illustrations are for the purpose of describing a preferred embodiment of the invention and are not intended to limit the invention thereto.

FIG. 1 is a schematic representation of an electrical component, in accordance with an exemplary embodiment of the invention.

FIG. 2 is a schematic representation of a side view of a switch in an open position, in accordance with an exemplary embodiment of the invention.

FIG. 3 is a schematic representation of a side view of a switch in a closed position, in accordance with an exemplary embodiment of the invention.

FIG. 4 is a schematic representation of a side view of a switch in a closed position, in accordance with an exemplary embodiment of the invention.

FIG. 5 is a schematic representation of an array of electrical components, in accordance with an exemplary embodiment of the invention.

### DETAILED DESCRIPTION

In the following description, whenever a particular aspect or feature of an embodiment of the invention is said to comprise or consist of at least one element of a group or combinations thereof, it is understood that the aspect or feature may comprise or consist of any of the elements of the group, either individually or in combination with any of the other elements of that group.

As used herein, the term "switch" refers to a device that can be used to connect and disconnect two parts of an electrical component. The mechanism of operation of such switches may be mechanical, or it may be electrical, or it may be chemical, or it might be a combination of the above. A suitable non-limiting example of such a switch is a micro-electro-mechanical switch.

As used herein, the term "adjacent," when used in context of discussion of different parts comprising the electrical component may refer to the situation where the parts under discussion are immediately next to each other, or it may also refer to a situation wherein intervening parts are present between the parts under discussion.

As used herein, the term "communication," when used in context of discussion of at least two parts of the electrical component means that electrons are able to tunnel or otherwise flow between the at least two parts under consideration.

As used herein, the term "work function" refers to the minimum energy (usually expressed in electron volts) needed to remove an electron from a neutral solid to a point immediately outside the solid surface (or energy needed to move an electron from the Fermi energy level into vacuum). Here "immediately" means that the final electron position is far from the surface on the atomic scale but still close to the solid surface on the macroscopic scale. Extraction of electrons from the surface of a solid, wherein the solid is a metal, can be induced via several methods of excitation based on different phenomena, such as photoelectric phenomena, thermionic phenomena, and electric field phenomena. Accordingly, the work function may be referred to as photoelectric work function, thermionic work function, and electric field work function.

As used herein, the term "tunneling" refers to the quantum mechanical phenomenon, usually important only at nanometer length scales, in which a particle, such as, an electron, violates the priniciples of classical mechanics by penetrating or passing though a potential energy barrier whose magnitude is greater than the kinetic energy of the particle. The term "barrier" as used herein in the context of quantum tunneling, may be imagined as an energy state analogous to a hill or an incline, which, according to classical mechanics, would be impossible to cross for the given energy of the particle such as an electron.

As used herein, the term "surface roughness" is a measure of the small scale variations in the height of a mechanical surface. This property is to be distinguished from large scale variations, which may be, for instance, part of the geometry of the surface. Surface roughness plays an important role in the phenomena of, for instance, friction, wear, drag, and fatigue. Surface roughness may be quantified as, for instance, root mean square roughness.

As used herein, the term "asperity," when used in the context of discussion of a macroscopically "flat"surface, refers to the rough, sharp, or rugged features present on the surface that contribute to the surface roughness of a component. One may visualize an asperity as a protuberance in the small-scale topographical irregularities of a solid surface. It is closely related to the term surface roughness and in some situations, the two terms may be used interchangeably.

As used herein, the terms "electrical contact" and "electrical contact surface" are closely inter-related, and may sometimes be used interchangeably. This is in recognition of the fact that electrical communication between any two solid electrical contacts takes place via surfaces of the electrical contacts, i.e., an "electrical contact" refers to that portion of the electrical device that enables electrical communication with adjacent portions. On the other hand, "electrical contact surface" surface refers to the surface of the electrical contact across which said electrical communication occurs.

As used herein, the term "open," when used in the context of discussion of an amount of communication and/or a state of electrical contact between two electrical contact surfaces refers to the situation wherein no or negligible amount of electrical current flows between the two electrical contact surfaces. In similar vein, as used herein, the term "closed," when used in the context of discussion of an amount of communication and/or a state of electrical contact between two electrical contact surfaces, refers to the situation wherein an amount of electrical current that is significant in the given situation flows between the two electrical contact surfaces.

For a particular material and for a particular method of exciting the electrons for emission, the actual "effective" value of the work function may depend upon several factors, including but not limited to, orientation of the underlying crystal lattice of the material with respect to the souce of excitation, the nature and quality of the surface, the presence of additional layers of other materials on the surface, the chemical composition of these material, the type and number of differing types of chemical bonds present in the material, and so on. Therefore, it is to be understood that the effective work function of any electrical component may vary depending on situation-specific parameters. It is pointed out that the nature and quality of surface may depend on a plurality of system and environment parameters, which may be interrelated, including, but not limited to, the chemical composition of the component, the presence of any dopants in the low work function material that comprises the low work function component, the level of doping of the dopant, the microstructure/morphology of the component, the level of crystallinity of the component, the level of mechanical strain present in the component, the temperature of the component, and the type and nature of the bias applied to the component. The microstructure/morphology of the low work function layer may depend on the method used to fabricate the low work function component.

Any real surface has a certain amount of roughness. Accordingly when two surfaces are bought into "contact" or electrical communication, the actual surface area of electrical contact is likely less than the surface area of overlap of the two surfaces, due to the interaction of the asperities on the respective surfaces. Electrical conduction can take place from one surface to another when they are in mechanical electrical contact, or if a distance separates the two surfaces, then it may occur, under appropriate conditions, via the quantum mechanical phenomena of tunneling between the two surfaces. Thus, electrical contact between two surfaces may be improved by fashioning the surfaces to have features so that a probability of tunneling of electrons between the two surfaces is increased. As a suitable non-limiting example, the electrical surfaces may be fashioned to be nano-structured, to enhance the tunneling probability between them. In one embodiment, the electrical contact includes one or more tunneling structures, where each structure may include one or more protuberances/bumps. The protuberances may also incorporate a sharp tip feature suitably shaped and disposed so as to enhance the tunneling probability, in turn leading to an enhancement of current flow between the electrical contacts. The fabrication methods of such features are well known in the art (see for instance, Ma et al., US Patent No. 6, 967, 548 B2 as a non-limiting example).

The electrical contact resistance and the likelihood of electrical contact seizure are important figures of merit of MEMSs. Both of these depend on, amongst other factors, the evolution over time of the "adhesion" between the two surfaces in question when they are bought in electrical communication. Electrical switches necessarily include at least two contact surfaces and traditionally these switches have enabled electrical communication between any two electrical contact surfaces via actual mechanical contact, wherein the electrical communication takes place via the mechanism of conduction. There are two aspects to the reliability over time of such a mechanical contact: the first is the inevitable presence of asperities, as noted above, which are present at the surfaces of both electrical contacts and result in an effective electrical contact area that is less than the overlap area. The second aspect concerns the repeated "making" and "breaking" of mechanical contact between the two contact surfaces, resulting in a degradation of the integrity of the electrical contact surfaces. This may be understood by considering the factors on which depend the characteristics of the electrical conduction between the two electrical contacts, such as, the material of the different parts which are in electrical communication, and material transfer during operation, which in turn leads to a roughening of the electrical contact surfaces in electrical communication. Surface roughening results in a reduction of the effective electrical contact area, which, via the accompanying increase in the electrical contact resistance may further result in an increased likelihood of arcing between, and welding/shorting of, the electrical contacts.

It may therefore be advantageous to limit the extent, and possibly remove altogether, the requirement for actual mechanical electrical contact between any two electrical contacts for the purposes of adequate electrical communication between the two. The above mentioned drawbacks of the prior art switches can be mitigated by employing electrical contacts that do not require mechanical contact for their operation, such as electrical contacts wherein the dominant mechanism of electrical communication is electron tunneling.

The probability of tunneling of electrons between two surfaces depends upon several potentially interrelated factors, such as the distance between the two surfaces and the work function of an emitting surface. The higher the work function, the more is the energy required by an electron to escape from the said material. As is well known in the art, it is likely that when electrical conduction or communication is occurring between any two electrical contact surfaces, then they can be disposed adjacent to each other in several manners. For instance, they may be in mechanical electrical contact. Another possibility is that they may be touching only at their asperities. Yet another possibility is that the two electrical contact surfaces are separated by a distance that is larger than the average asperity size of either of the electrical contact surfaces, and then, electrical conduction between the electrical contact surfaces will take place via tunneling. In any real situation of electrical conduction between any two electrical contacts, it is likely that any or all three modes are present in varying degrees.

Providing an electrical contact composed of one or more low work function materials is therefore a method to enhance the electrical communication between the said electrical contact and any other adjacent electrical contacts. In one embodiment of the present invention, to ensure enhanced electrical conduction between any two electrical contacts, the electrical contacts may be composed of low work function materials. Reduction of wear of electrical contacts can be achieved by maintaining the distance between the two surfaces at a well defined, albeit low value, such that there is no direct mechanical electrical contact between the two surfaces. No direct mechanical electrical contact implies less likelihood of wear of surface due to surface roughening caused by wear and tear due to repeated making and breaking of mechanical electrical contact between the two electrical contact surfaces.

In one embodiment of the invention, at least one of the at least two electrical contacts includes a material having a work function that is less than about 3.5 electron volt (eV). In another embodiment on the invention, at least one of the at least two electrical contacts includes a material having a work function that is less than about 2 eV. In one embodiment on the invention, at least one of the at least two electrical contacts includes a material having a work function that is less than about 1 eV.

The at least two electrical contacts may be, for instance, electrical contacts independently including at least one surface each. Different surfaces from the different electrical contacts may independently be brought into electrical communication with each other. The amount and type of electrical communication between the at least two electrical contacts may depend on many factors, including but not limited, to the materials from which the electrical contacts are composed and whether or not there are present additional layers, which may be thin film layers, on the surface of the electrical contacts; the distance between the two electrical contacts; and the environment in which the electrical contacts are placed.

The amount and type of electrical communication between the at least two electrical contacts may depend on materials from which the electrical contacts are fabricated. It is generally known in the art that the probability of emission of an electron from a material increases as the work function of the material decreases. For causing electric field induced emission of electrons, an electric field may be generated at the electrical contact, for instance, by applying an electric voltage between the two electrical contacts. The negative terminal of the voltage should be applied to the electrical contact from which electron emission is sought.

The amount and type of electrical communication between the at least two electrical contacts may further depend on the surface roughness of the electrical contacts. In one embodiment, the surface roughness of the electrical contacts is between about 0.5 nanometer (nm) to about 2 nm.

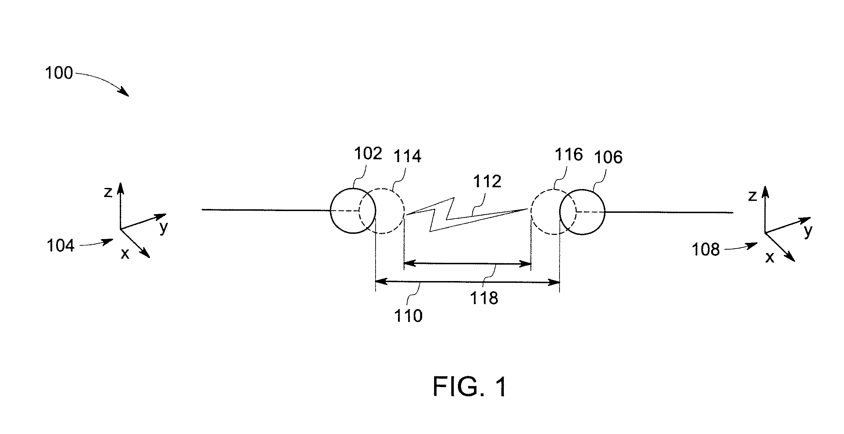

FIG. 1 is a schematic representation of one embodiment of an electrical component 100. The illustrated embodiment includes a first electrical contact 102 that may be capable of movement in space, as depicted by the coordinate axes system 104. The illustrated embodiment further includes a second electrical contact 106 that may also be capable of movement in space, as depicted by the coordinate axes system 108. A first distance 110 separates the two electrical contacts 102 and 106. For the purposes of illustration, this first distance 110 may be considered to be in an "open" position, i.e., an electrical communication 112, between the first electrical contact 102 and the second electrical contact 104 is negligible. Now, as has been mentioned, the first and the second electrical contact 102 and 106 generally may be independently capable of movement in space. As a result of such movement, bought about via a suitable actuation mechanism, the first and second electrical contacts, indicated now as elements 114 and 116 respectively, can be placed such that a second distance 118 between them is less than the first distance 110 between them. This second distance may be such that the electrical component is in a "closed" position, i.e., an electrical communication 112, between the first electrical contact 102 and the second electrical contact 104 is significant.

In an exemplary embodiment of the invention, the invention contains two electrical contacts 102 and 106 arranged so that one of the electrical contacts is fixed and the other is movable to change the extent of the electrical communication between the two electrical contacts. The two electrical contacts may be in a "closed" position, which for instance refers to a situation wherein a distance between the electrical contacts is small enough to allow for desired amount of electrical communication between the two electrical contacts. This situation does not necessarily mean that the two electrical contacts need to be in mechanical contact whereby the electrical communication between the two is via conduction. Rather, because of the drawbacks associated with direct mechanical contact between two electrical contacts, it refers to the situation wherein a finite, albeit small, distance separates the electrical contacts, so that the electrical contact resistance between the electrical contacts is at a low value. On the other extreme, the two electrical contacts might be in "open" position, which for instance, might include the situation wherein a distance separates the electrical contacts, wherein the distance is large enough to severely limit the amount of electron transfer between the two electrical contacts. Without being limited by any particular theory, it is likely that the electrical contact resistance between any two electrical contacts when they are in closed position, depends on several factors, including but not limited to, the geometry of the electrical contacts. In one embodiment of the invention, the resistance between the electrical contacts, when they are in an open position, is greater than about 1 megaohm (MΩ).

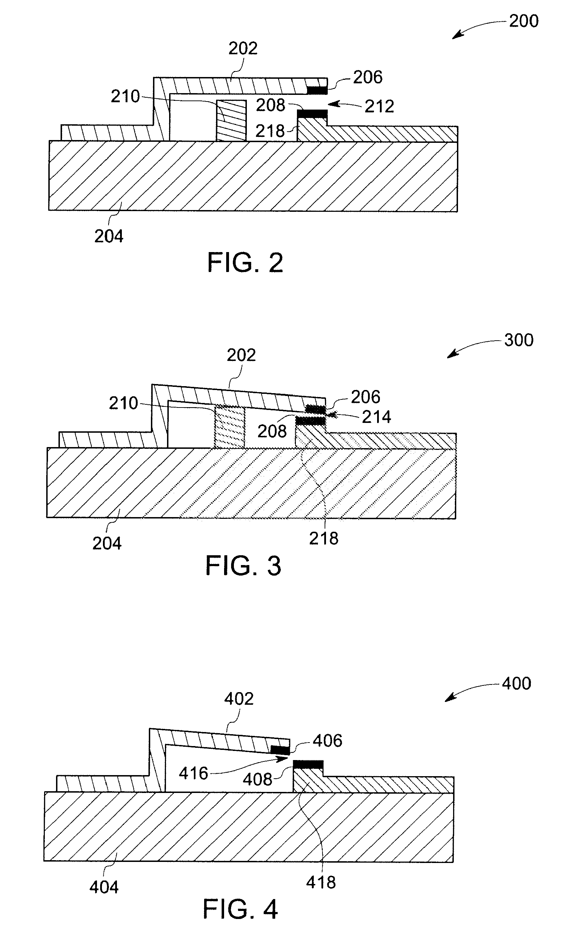

FIG. 2 is a cross-sectional view of an embodiment of the electrical component 100 when component 100 is a switch 200. Switch 200 includes a movable connecting member 202 that may be anchored to an underlying substrate 204. The movable connecting member 202 may have an electrical contact surface 206 that includes a low work function material. The illustrated embodiment further includes a second electrical contact 218 having a second electrical contact surface 208. The second electrical contact surface 208 may also include a low work function material. The illustrated embodiment also includes a mechanical member 210 which may help in maintaining a minimum distance between the two electrical contact surfaces 206 and 208. A first distance 212 separates the first electrical contact surface 206 and the second electrical contact surface 208. Without loss of generality, the value of the first distance 212 is such that the switch is in an "open" state.

A movement of the movable connecting member 202 can be brought about via various mechanisms, including, but not limited to, electrostatic actuation, or piezoelectric actuation, as is well known in the art. An embodiment of the invention includes a system (not shown) to control and/or maintain the distance/angle between the at least two electrical contact surfaces 206 and 208. This system may include various sub-systems such as electronic and computer control systems, which may include feedback circuitry, and vibration isolation systems, amongst other sub-systems. The control systems may incorporate feedback circuits, as are used in, for instance, control systems of atomic force microscopes, or scanning tunneling microscopes, or nano-positioners. The control system may also include a mechanical sub-system or member that aids in maintaining a desired gap between the at least two electrical contact surfaces 206 and 208. In one embodiment, the mechanical sub-system or member includes any arrangement that prevents or minimizes mechanical "touching" between any of the at least two electrical contact surfaces between which electrical communication is desired. For instance, the mechanical sub-system can be in the form of one or more mechanical stops 210 positioned to prevent mechanical touching between the at least two electrical contacts while still allowing for electrical communication via tunneling between the at least two electrical contacts. Another non-limiting example arrangement (discussed below) may entail fashioning the movable connecting member 202 to have physical dimensions and/or shapes such that the possibility of mechanical contact between the electrical contacts is precluded, but the ability of electrical communication between them is retained.

FIG. 3 is a cross-sectional view 300 of switch 200 when it is in "closed" position. The mechanical member 210 helps in maintaining a minimum distance between the two electrical contact surfaces 206 and 208. The element 214 indicates a second distance between the first electrical contact surface 206 and the second electrical contact surface 208. The value of the second distance 214 is less than the first distance 212, and, without loss of generality, the switch may be said to be in a "closed" state.

FIG. 4 is a cross-sectional view of switch 400. The switch 400 is similar to the switch 200 as has been described, having a movable connecting member 402 that may be anchored to an underlying substrate 404. The movable connecting member 402 may have a first electrical contact surface 406 that includes a low work function material. The illustrated embodiment further includes a second electrical contact 418 having a second electrical contact surface 408. The second electrical contact surface 408 may also include a low work function material. The element 416 indicates a gap between the first electrical contact surface 406 and the second electrical contact surface 408. It is clear that due to the physical dimensions, and/or shape, and/or arrangement of the movable connecting member 402 and the second electrical contact 418, a non-zero gap 416 may be maintained, thereby minimizing the possibility of mechanical contact between the electrical contacts 406 and 408. However, the ability of electrical communication between them is retained via the tunneling mechanism.

In one embodiment of the invention, such as for instance shown in FIG. 2, the electrical component 200 includes at least two electrical contact surfaces 206 and 208 movable relative to each other between an open position and a closed position. In one embodiment, the invention is configured to constrain a distance between the electrical contacts, when they are in closed position, to lie within a range from greater than 0 nm up to about 30 nm. In another embodiment, the invention is configured to constrain a distance between the electrical contacts, when they are in closed position, to lie within a range greater than 0 nm to about 4 nm. In another embodiment, the invention is configured to constrain a distance between the electrical contacts, when they are in closed position, to lie within a range greater than 0 nm to about 1 nm.

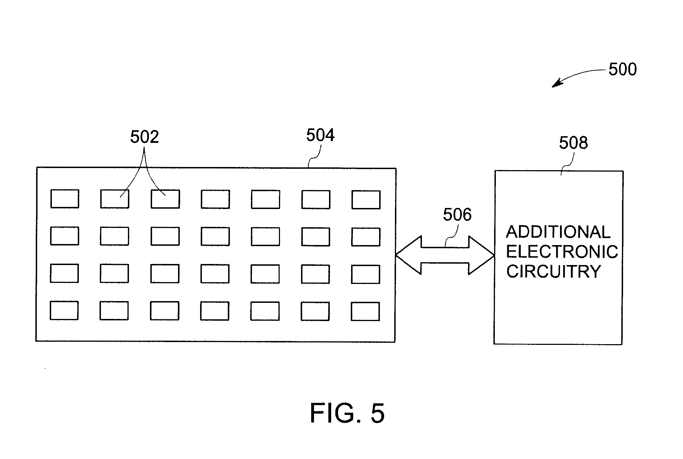

FIG. 5 is a schematic view of an array 500 of electrical components in accordance with an embodiment of the invention. The array 500 includes a plurality of electrical components 502, which may be housed within packaging 504. The electrical switches may independently be MEMS devices. The array 500 may also include other components, such as a communication channel 506 to communicate with additional electronic circuitry 508, which may aid in realizing a given function or task that the array is tasked to perform.

In one embodiment, a low work function electrical contact may include a material comprising cesium, potassium, sodium, barium, calcium, gallium nitride, magnesium, aluminum, silver, silicon, titanium dioxide, diamond like carbon (DLC), gold, ruthenium, or combinations thereof. Examples of such combinations of materials include, but are not limited to, silicon plus cesium plus oxygen, barium plus strontium plus calcium plus oxygen, silver plus cesium plus oxygen, electrides, and gold plus cesium. In an exemplary embodiment of the invention, the material of the electrical contact 206 and/or 208 can be an alloy of cesium and gold, having 20-50% cesium. In one embodiment, the alloy may contain about 30% cesium. In another embodiment, the alloy may contain about 40% cesium. In yet another embodiment, the alloy may contain about 50% cesium.

In some embodiments, the contact includes a layer disposed on a surface of an electrical contact. (In this sense, the electrical contact serves as a "substrate" for the layer.) Such layers, which may be, for instance, thin film layers, or layers that are just a few atoms thick, or monoatomic layers, may independently be deposited onto the electrical contacts, and may themselves be fabricated out of low work function materials. The "few atoms thick" layers, or monoatomic layers, may be disposed on the surface of the electrical contacts via adsorption at their surface. Suitable examples of materials from which such layers may be composed include, but are not limited to, barium oxide, barium nitride, titanium dioxide, DLC, cesium, and combinations thereof. Suitable examples of materials from which such substrates may be composed include, but are not limited to, silicon, platinum, gold, and combinations thereof. A suitable non-limiting example of a material from which a monoatomic layer may be composed is cesium. Specific examples of coating-substrate combinations suitable for use in some embodiments include, but are not limited to, barium oxide deposited on silicon, barium nitride deposited on silicon, titanium dioxide deposited on platinum, DLC deposited on silicon, and cesium deposited on gold.

In some embodiments, component 100 further comprises an insulating layer (not shown) disposed on at least one of the electrical contacts 102, 106. This insulating layer is designed to at least partially fill the gap (second distance 118) between contacts 102, 106 when they are in the closed position. In some embodiments, substantially the entire gap is filled by the insulating layer, while in other embodiments, the gap is only partially filled by the insulating layer. The presence of the insulating layer will likely minimize the requirement for physical movement of the electrical contacts, as well as minimize the possibility of mechanical contact between the electrical contacts. Both of these aforementioned features would likely result in improved figures of merit for these switches in comparison to traditional switches which require mechanical contact for electrical communication between the electrical contacts. In one embodiment, such insulating layers may further result in a modification of a distribution of the electromagnetic field that is present within a gap region present between the two electrical contact surfaces. It is possible that the said modification in the electric field actually increases, under appropriate conditions, the tunneling probability between the electrical contacts.

The layers described above may be deposited by any suitable method or combinations of such methods, such as, plasma enhanced chemical vapor deposition (PECVD), low pressure chemical vapor deposition (LPCVD), sputtering, evaporation, and atomic layer deposition.

In some embodiments the thickness of the layer is up to about 100 nm. Conceivably, the layer itself is also likely to have a certain amount of surface roughness. It is also possible that the thickness of the film determines, at least to a partial extent, the surface roughness of the film.

In one embodiment of the invention, electrical component 100 is a MEMS switch device including at least two electrical contacts movable relative to each other between an open position and a closed position, wherein a mechanical distance 212 between the electrical contacts in the closed position is a non-zero value up to about 30 nm. It is likely that the change in the mechanical distances between the at least two electrical contacts 206 and 208, due to their relative movement, may be one of the factors affecting the change in the electrical communication between the at least two electrical contact surfaces 206 and 208. In one embodiment of the invention, at least one of the at least two electrical contact surfaces 206, 208 includes a material having a work function that is less than about 3.5 electron volt (eV). In another embodiment of the invention, at least one of the at least two electrical contacts includes a material having a work function that is less than about 2 eV. In one embodiment of the invention, at least one of the at least two electrical contacts includes a material having a work function that is less than about 1 eV.

In one embodiment of the invention, the MEMS device is disposed in a hermetically sealed chamber. The techniques for hermetically sealing a chamber to house MEMSs and MEMS arrays are well known in the art. In another embodiment of the invention, an environment within the hermetically sealed chamber comprises an inert gas or vacuum. As described previously, the amount and type of electrical communication between the at least two electrical contacts may depend on the environment within which are placed the at least two electrical contacts 206 and 208. For example, when the electrical component is a MEMS having a movable connecting member in the form of a cantilever, then a damping force to the movement of the cantilever may be provided via the ambient gases surrounding the cantilever. The composition, temperature, and pressure of the ambient gases, amongst other factors, are factors that may be important in this respect. In this sense, the environment may also serve to modify the mechanical properties, and in turn the electrical communication properties, of the individual electrical contacts.

MEMS switches typically include a suspended connecting member, which can be fashioned in various geometries. One of the possible geometries is the "cantilever" geometry, in which the suspended connecting member is in the form of a beam that is anchored to an underlying substrate at a location substantially close to one of the ends of the beam. Another possible geometry is the "see-saw" geometry, in which the suspended connecting member, which may be in various forms, including but not limited to a beam, is anchored to an underlying substrate at a location substantially removed from each of its ends. The aforementioned cantilever and see-saw geometries are well known in the art (see for instance, De Los Santos et al., US Patent No. 6,040,611). Yet another possible geometry is the "bridge" geometry, in which the suspended connecting member, which may be in various forms, including but not limited to a beam, is anchored to an underlying substrate at two locations, both of which are substantially towards the ends of the beam. The aforementioned bridge geometry is well known in the art (see for instance, Ma Qing, European Patent No. 1,529,300 B1). Yet another possible geometry is the "membrane" geometry, in which the suspended connecting member is in the form of a sheet that is substantially flexible in the given situation, and which is anchored at multiple and possibly a continuum of points along its periphery, to an underlying substrate. It is possible to have combinations of the above possible geometries, as well. The aforementioned membrane geometry is well known in the art (see for instance, Ma Qing, US Patent No. 6,880,235 B2).

One embodiment of the invention, such as for example, the embodiment shown in FIG. 5, includes a plurality of electrical switches, 502 wherein each electrical switch comprises at least two electrical contacts movable relative to each other in an open position and a closed position; wherein at least one of the electrical contacts comprises a material having a work function that is less than about 3.5 eV, and wherein a distance between the electrical contacts, in the closed position, is between greater than 0 nm to about 30 nm.

In one embodiment of the invention, the component 100 comprises an electrical power device. In one embodiment of the invention, the power device is a motor-starter. Motor-starters are devices that enable the changeover of a motor from a deenergized state to an energized state in a controlled manner. Different types of motor starters may be advantageous in different situations and the choice of a motor-starter that is appropriate in a given situation depends on the required characteristics of the energization procedure and available control circuitry, among other factors. Because of their reduced mechanical dimensions, the electrical currents and electrical voltages that can be reliably handled by an individual MEMS is likely less than those that can handled by individual traditional electrical switches. This limitation can be circumvented, or at least mitigated, by fabricating electrical switches that include one or more arrays of MEMS electrical switches. Each such array can be composed of a plurality of MEMS electrical switches of the type described herein. An arrangement of the plurality of MEMS electrical switches may then be implemented so as to suitably distribute the currents and voltages encountered during operation of the electrical power device, among said plurality of MEMS electrical switches.

MEMS fabrication processes constitute a well developed art that is constantly being improved. Standard techniques such as lithographic techniques, including photolithographic techniques, wet etching and/or dry etching, thin film deposition techniques such as chemical vapor deposition (CVD) techniques and/or mechanical vapor deposition techniques, thin film growth techniques such as via oxidation and/or epitaxial techniques, doping techniques such as via ion implantation, are well known processes that are readily adaptable for fabricating MEMSs and arrays of MEMSs. Lithographic techniques such as, photolithographic techniques, may be used to in the fabrication of these electrical components. Electromagnetic radiation, i.e., light, is used to transfer a geometric pattern from a photomask to a photoresist, i.e., light sensitive chemical. A series of chemical treatments then engraves the exposure pattern into the material underneath the photoresist. These steps may be repeated several times before the final component is fashioned in desired form.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

Aspects of the present invention are defined in the following numbered clauses:
1. An electrical component comprising:
   at least two electrical contacts movable relative to each other between an open position and a closed position;
   wherein at least one of the electrical contacts comprises a material having a work function that is less than about 3.5 eV; and
   wherein the distance between the electrical contacts, in the closed position, is greater than 0 nm and up to about 30 nm.
2. The electrical component of clause 1, wherein the at least one of the electrical contacts comprises a material having a work function that is less than about 2 eV.
3. The electrical component of clause 1 or clause 2, wherein the at least one of the electrical contacts comprises a material having a work function that is less than about 1 eV.
4. The electrical component of any one of the preceding clauses, wherein the at least one electrical contact comprises a material comprising cesium, potassium, sodium, barium, calcium, gallium nitride, magnesium, aluminum, silver, silicon, titanium dioxide, DLC, gold, ruthenium, or combinations thereof.
5. The electrical component of any one of the preceding clauses, wherein at least one of the at least two electrical contacts comprises a layer disposed on a substrate.
6. The electrical component of any one of the preceding clauses, further comprising an insulating layer disposed on at least one electrical contact of the at least two electrical contacts, wherein the insulating layer at least partially fills the distance between the at least two electrical contacts in the closed position.
7. The electrical component of any one of the preceding clauses, wherein the resistance between any two of the at least two electrical contacts in the open position is greater than about 1 MΩ.
8. The electrical component of any one of the preceding clauses, wherein the surface roughness of the electrical contacts is up to about 2 nm.
9. The electrical component of any one of the preceding clauses, wherein the electrical component is a switch.
10. The electrical component of clause 9, wherein the switch comprises a MEMS device.
11. The electrical component of clause 10, wherein the MEMS device is disposed in a hermetically sealed chamber.
12. The electrical component of clause 11, wherein an environment within the hermetically sealed chamber comprises an inert gas.
13. The electrical component of clause 11, wherein an environment within the hermetically sealed chamber comprises vacuum.
14. The electrical component of any one of the preceding clauses, comprising a system to control the distance between the two electrical contact surfaces, wherein said system comprises a mechanical member.
15. The electrical component of clause 14 wherein the mechanical member comprises a mechanical stop.
16. A device comprising:
   a plurality of electrical switches;
   wherein each electrical switch comprises at least two electrical contacts movable relative to each other between an open position and a closed position; and
   wherein at least one of the electrical contacts comprises a material having a work function that is less than about 3.5 eV; and
   wherein the distance between the electrical contacts, in the closed position, is greater than 0 nm and up to about 30 nm.
17. The device of clause 16, wherein at least one of the plurality of electrical switches comprises a MEMS device.
18. The device of clause 16 or clause 17, wherein the device is disposed in a hermetically sealed chamber.
19. The device of clause 18, wherein an environment within the hermetically sealed chamber comprises an inert gas.
20. The device of any one of clauses 16 to 19, wherein the device comprises an electrical power device.
21. The device of clause 20, wherein the power device is a motor-starter.

## Claims

1. An electrical component comprising:
at least two electrical contacts movable relative to each other between an open position and a closed position;
wherein at least one of the electrical contacts comprises a material having a work function that is less than about 3.5 eV; and
wherein the distance between the electrical contacts, in the closed position, is greater than 0 nm and up to about 30 nm.

2. The electrical component of claim 1, wherein the at least one of the electrical contacts comprises a material having a work function that is less than about 2 eV.

3. The electrical component of claim 1 or claim 2, wherein the at least one electrical contact comprises a material comprising cesium, potassium, sodium, barium, calcium, gallium nitride, magnesium, aluminum, silver, silicon, titanium dioxide, DLC, gold, ruthenium, or combinations thereof.

4. The electrical component of any one of the preceding claims, wherein at least one of the at least two electrical contacts comprises a layer disposed on a substrate.

5. The electrical component of any one of the preceding claims, further comprising an insulating layer disposed on at least one electrical contact of the at least two electrical contacts, wherein the insulating layer at least partially fills the distance between the at least two electrical contacts in the closed position.

6. The electrical component of any one of the preceding claims, wherein the resistance between any two of the at least two electrical contacts in the open position is greater than about 1 MΩ.

7. The electrical component of any one of the preceding claims, wherein the surface roughness of the electrical contacts is up to about 2 nm.

8. The electrical component of any one of the preceding claims, wherein the electrical component is a switch.

9. The electrical component of claim 9, wherein the switch comprises a MEMS device.

10. The electrical component of any one of the preceding claims, wherein the MEMS device is disposed in a hermetically sealed chamber.

11. The electrical component of claim 10, wherein an environment within the hermetically sealed chamber comprises an inert gas.

12. The electrical component of claim 10, wherein an environment within the hermetically sealed chamber comprises vacuum.

13. The electrical component of any one of the preceding claims, comprising a system to control the distance between the two electrical contact surfaces, wherein said system comprises a mechanical member.

14. The electrical component of claim 13 wherein the mechanical member comprises a mechanical stop.

15. A device comprising:
a plurality of electrical switches;
wherein each electrical switch comprises at least two electrical contacts movable relative to each other between an open position and a closed position; and
wherein at least one of the electrical contacts comprises a material having a work function that is less than about 3.5 eV; and
wherein the distance between the electrical contacts, in the closed position, is greater than 0 nm and up to about 30 nm.
